# EUROPÄISCHE PATENTSCHRIFT

(11) **EP 1 709 575 B1**
(45) Veröffentlichungstag und Bekanntmachung des Hinweises auf die Patenterteilung: **19.08.2009**
(21) Anmeldenummer: 05706715.9
(22) Anmeldetag: 28.01.2005
(51) Int. Cl.: G06K 19/077, G06K 19/18

(54) **SICHERHEITSLAGENAUFBAU UND EINEN SOLCHEN ENTHALTENDE IDENTIFIKATIONSDOKUMENTE**
SECURITY LAYER STRUCTURE, AND IDENTIFICATION DOCUMENTS CONTAINING SUCH A SECURITY LAYER STRUCTURE
STRUCTURE A COUCHES DE SECURITE ET DOCUMENTS D'IDENTIFICATION CONTENANT CETTE STRUCTURE A COUCHES DE SECURITE

(30) Priorität: 28.01.2004 DE 102004004469
(43) Veröffentlichungstag der Anmeldung: 11.10.2006
(73) Patentinhaber: Smartrac IP B.V., 1077 XX Amsterdam (NL)
(72) Erfinder: RIETZLER, Manfred, 87616 Marktoberdorf (DE)
(74) Vertreter: Tappe, Hartmut
(86) Internationale Anmeldenummer: PCT/DE2005/000125
(87) Internationale Veröffentlichungsnummer: WO 2005/073907

(56) Entgegenhaltungen:
- EP-A- 0 745 955
- DE-A1- 4 410 732
- DE-A1- 10 032 128
- DE-A1- 10 201 112
- DE-A1- 10 205 914

## Beschreibung

Die vorliegende Erfindung betrifft einen Sicherheitslagenaufbau zur Verwendung als Ausweisseite eines Personaldokuments oder zur Verwendung als Personaldokument im Chipkartenformat gemäß dem Oberbegriff des Anspruchs 1 oder 2. Des Weiteren betrifft die vorliegende Erfindung ein Identifikationsdokument zur Personenidentifikation mit einem derartigen Sicherheitslagenaufbau.

Sogenannte kontaktlose Karten, die einen kontaktlosen Zugriff auf einen Speicherchip ermöglichen, der zusammen mit einer Antennenspule einen sogenannten Transponder bildet, sind schon länger im Einsatz und werden bevorzugt im Zusammenhang mit automatisierten Zutrittskontrollen eingesetzt. Als Beispiel hierfür können Zutrittskontrollen im Bereich der Fahrgastbeförderung im Nahverkehrsbereich oder auch automatisierte Zutrittskontrollen an Skiliftanlagen genannt werden.

Weiterhin ist es auch bekannt, derartige kontaktlose Karten im Bereich sicherheitsrelevanter Zutrittskontrollen zu verwenden, um beispielsweise nur bestimmten Personen den Zutritt zu den Bereichen zu ermöglichen.

Abgesehen von den vorstehend genannten Einsatzbereichen ist jedoch bislang keine allgemeine Verwendung kontaktloser Karten oder allgemein kontaktloser, elektronisch lesbarer Personenidentifikationsträger bekannt, da einer allgemeinen ausnahmslosen Verwendung häufig das Fehlen einer entsprechenden Infrastruktur oder Peripherie zur Erfassung elektronisch gespeicherter Daten entgegensteht.

Darüber hinaus ist teilweise auch noch eine mangelnde Akzeptanz elektronischer Personenidentifikationssysteme erkennbar, die häufig darauf zurückzuführen ist, dass eine Authentizitätskontrolle der verwendeten Personenidentifikationsträger nicht ohne Weiteres möglich ist.

Aus der DE 100 32 128 A1 ist ein Sicherheitselement bekannt, das durch Anordnung auf der Oberfläche eines Sicherheitspapiers ein fälschungssicheres Wertdokument ermöglichen soll. Bei dem bekannten Sicherheitselement ist ein auf einem Transpondersubstrat angeordneter Drahtleiter mit einer Kleberschicht abgedeckt, die die Anbringung des Sicherheitselements auf der Oberfläche des Sicherheitspapiers ermöglicht.

Die Ansprüche 1 und 2 sind gegen dieses Dokument abgegrenzt.

Aus der DE 102 05 914 A1 ist ein Verfahren zur Herstellung von Polyesterfolien mit einer Transponderantennenspule bekannt, wobei eine Verwendung einer derartigen Polyesterfolie zur Herstellung einer IC-Karte erläutert wird. Hierzu wird vorgeschlagen, eine mit einem Chip kontaktierte, auf einem Transpondersubstrat angeordnete Leiteranordnung, die mit einer stabilisierenden Folie abgedeckt ist, mit einer weiteren äußeren Deckschicht zu versehen.

Die DE 44 10 732 A1 zeigt ein Verfahren zur Herstellung einer Chipkarte, bei dem eine aus einem Drahtleiter ausgebildete Spule auf der Oberfläche eines Transpondersubstrats angeordnet und nachfolgend der Kontaktierung mit einem Chip durch eine Decklage abgedeckt wird.

Aus der EP 0 745 955 A2 ist ein Verfahren zur Herstellung einer Chipkarte bekannt, bei dem der auf einem Substrat angeordnete Chip zur Versiegelung mit einem Kunststoff umspritzt wird.

Die DE 102 01 112 A1 zeigt ein Verfahren zur Herstellung einer Chipkarte basierend auf einem laminierten Lagenaufbau.

Der vorliegenden Erfindung liegt die Aufgabe zugrunde, einen Sicherheitslagenaufbau vorzuschlagen, der zur Verwendung als Ausweisseite oder als Personaldokument im Chipkartenformat bei hermetisch versiegelter Aufnahme des Chips eine lediglich geringe Stärke mit planparalleler Ausbildung der Oberflächen des Sicherheitslagenaufbaus ermöglicht.

Diese Aufgabe wird durch einen Sicherheitslagenaufbau mit den Merkmalen des Anspruchs 1 oder 2 gelöst.

Der erfindungsgemäße Sicherheitslagenaufbau ermöglicht die einfache Integration eines Transponders, umfassend einen zur Ausbildung einer Spule dienenden Drahtleiter und eine damit kontaktierte Chipanordnung, in einen Lagenaufbau, der zur Verwendung als Ausweisseite für ein Personaldokument oder zur Verwendung als Personaldokument im Chipkartenformat in besonderer Weise dadurch geeignet ist, dass eine Sichtseite einer Decklage oder eine Sichtseite einer auf den Decklagen jeweils angeordneten Einbanddecklage mit einem Sicherheitsdruck versehen ist.

Der erfindungsgemäße Sicherheitslagenaufbau für ein Identifikationsdokument weist eine Transponderlage und zwei Decklagen auf, wobei die Transponderlage zur Ausbildung zumindest einer Spulenwindung einen in einer Ebene auf einem Transpondersubstrat angeordneten Drahtleiter aufweist, der mit Anschlussflächen einer Chipanordnung kontaktiert ist. Das Transpondersubstrat ist aus einem thermoplastischen Kunststoff gebildet und zwischen den beiden Decklagen aufgenommen und versiegelt abgedeckt.

Die erfindungsgemäße Kombination des Sicherheitsdrucks mit dem den Transponder umfassenden Lagenaufbau schafft die Möglichkeit, entweder eine Authentizitätskontrolle auch ohne Zuhilfenahme elektronischer Datenabgriffsmittet zum Datenabgriff der auf der Chipanordnung gespeicherten Daten durch optische Kontrolle des Sicherheitsdrucks durch konventionelle Inaugenscheinnahme des Sicherheitsdrucks durchzuführen, oder mit den geeigneten Peripheriegeräten, insbesondere einer Leseeinrichtung zur Erfassung der in der Chipanordnung gespeicherten Personenidentifikationsdaten, eine Überprüfung der Identifikationsdaten durchzuführen.

Darüber hinaus ermöglicht der erfindungsgemäße Sicherheitslagenaufbau durch die Anordnung des Transponders und des Sicherheitsdrucks in bzw. an oder auf ein und demselben Sicherheitslagenaufbau durch die Zwangszuordnung zwischen den Speicherdaten auf der Chipanordnung und dem Sicherheitsdruck die Schaffung eines weitestgehend fälschungssicheren Personaldokuments. So ist es, insbesondere wegen der versiegelnden Abdeckung der Transponderlage, die beispielsweise durch eine flächige Verbindung der Decklage mit der Transponderlage in einem Laminier- oder auch Klebevorgang erfolgen kann, nicht möglich, die Zuordnung zwischen Sicherheitsdruck und Transponder ohne Zerstörung des Sicherheitslagenaufbaus zu ändern. Aus dem Vorstehenden ergibt sich, dass mit dem Begriff "versiegelnde Abdeckung" jegliche Abdeckung gemeint ist, die einen unmittelbaren Zugriff auf den Transponder bzw. die Chipanordnung verhindern soll.

Da der Sicherheitsdruck erfindungsgemäß personenspezifische Kenndaten aufweist, ermöglicht der Sicherheitsdruck nicht nur eine Authentizitätskontrolle bezüglich der Echtheit des Dokuments, sondern die Ausbildung eines dualen Identifikationssystems, das wahlweise eine automatisierte Erfassung der auf der Chipanordnung gespeicherten Daten durch einen Lesevorgang oder eine Erfassung der vom Sicherheitsdruck umfassten Kenndaten durch konventionelle Inaugenscheinnahme ermöglicht.

Erfindungsgemäß ist das Transpondersubstrat aus einem thermoplastischen Kunststoff gebildet und zwischen zwei Decklagen aus einem geschäumten Kunststoff aufgenommen.

Zum einen ermöglicht die vorgenannte Kombination infolge eines Eindringens des thermoplastischen Materials des Transpondersubstrats in die Poren des geschäumten Kunststoffs bei einem Laminiervorgang eine besonders gute Haftung der Schichtlagen aneinander. Zum anderen können auch in einem nachfolgenden Verfahrensschritt zur Ausbildung eines Buchdeckeleinbands basierend auf dem Sicherheitslagenaufbau die Decklagen mit anschließenden weiteren Lagen durch eine infolge der Porosität des geschäumten Kunststoffes besonders haltbare Klebeverbindung verbunden werden.

Erfindungsgemäß weist die gegenüberliegend einer Chipgehäusung angeordnete Decklage eine Fensteröffnung zur zumindest teilweisen Aufnahme der Chipgehäusung auf, so dass der Sicherheitslagenaufbau trotz der Ergänzung des Transpondersubstrats mit den Decklagen in einer möglichst geringen Stärke herstellbar ist.

Bei einer ersten erfindungsgemäßen Alternative gemäß Anspruch 1 ist die erfindungsgemäße Fensteröffnung der Decklage mit einem die Chipgehäusung überdeckenden Teilbereich des Transpondersubstrats derart verfüllt, dass der Teilbereich flächenbündig mit einer Oberseite der Decklage angeordnet ist.

Bei einer zweiten erfindungsgemäßen Alternative gemäß Anspruch 2 ist zur sicheren hermetisch abdichtenden Aufnahme des Chips gegenüberliegend der Chipgehäusung zwischen dem Transpondersubstrat und einer Decklage eine Siegellage vorgesehen, wobei die Fensteröffnung der Decklage mit einem die Chipgehäusung überdeckenden Teilbereich der Siegellage derart verfüllt ist, dass der Teilbereich flächenbündig mit einer Oberseite der Decklage angeordnet ist.

Beide erfindungsgemäßen Alternativen ermöglichen unabhängig voneinander eine planparallele Ausbildung der Oberflächen des Sicherheitslagenaufbaus, die die Aufbringung extrem dünner Einbanddecklagen ermöglicht, ohne dass Gefahr besteht, dass sich der Chip in der Oberfläche abzeichnet.

Bei einer möglichen Variante des Sicherheitslagenaufbaus ist der Drahtleiter auf dem Transpondersubstrat derart angeordnet, dass der Drahtleiter mit seinen für die Kontaktierung mit der Chipanordnung vorgesehenen Kontaktenden über die in einer Substratausnehmung angeordnete Chipanordnung hinweggeführt und mit den Anschlussflächen der Chipanordnung kontaktiert wird.

Wenn die Kontaktenden des Drahtleiters parallel zueinander und quer zu einem benachbarten Drahtleiterstrang verlaufen, ist eine besonders platzsparende Anordnung der Transponderanordnung auf dem Transpondersubstrat möglich. Dies gilt umso mehr, wenn ein Kontaktende mit einem Brückenbereich über den benachbarten Drahtleiterstrang hinweg verläuft.

Eine besonders haltbare Verbindung zwischen dem Drahtleiter und der Oberfläche des Transpondersubstrats ist gegeben, wenn der Drahtleiter zumindest anteilig mit seinem Drahtumfang in die Oberfläche des Transpondersubstrats eingebettet ist.

Insbesondere bei einer Verbindung des Drahtleiters mit einem Transpondersubstrat aus einem im Wesentlichen nicht plastisch verformbaren Material ist es vorteilhaft, wenn der Drahtleiter zumindest abschnittweise mit der Oberfläche des Transpondersubstrats verklebt ist.

Eine hohe Stabilität und Reißfestigkeit wird erreicht, wenn das Transpondersubstrat unter Verwendung eines Polyimids oder eines Polyimid-Derivates hergestellt ist.

Wenn das Transpondersubstrat eine Gewebestruktur aufweist, wird die Stabilität und Reißfestigkeit in unterschiedlichen Richtungen noch vergrößert. Darüber hinaus lässt sich eine Gewebestruktur besonders haltbar mit weiteren Lagen vernähen oder verkleben. Dies gilt besonders für ein Nylon-Gewebe.

Zur Verwendung für die Decklagen eignet sich in besonderer Weise ein Polyolefin-Schaumstoff. Insbesondere bei Verwendung eines Polyethylen-Schaumstoffs mit Siliciumdioxid als Füllstoff lassen sich papierartige Materialeigenschaften erzielen.

Insbesondere bei einer mehrlagigen Ausbildung des Transpondersubstrats und einer hierdurch ermöglichten Anordnung der Chipanordnung zwischen den Lagen kann eine besonders sichere, hermetische Versiegelung erreicht werden.

Wenn der Sicherheitslagenaufbau längs einer Faltachse zumindest eine Querschnittsverringerung zur Definition eines Buchrückens aufweist, ist selbst bei relativ steifer Ausbildung des Sicherheitslagenaufbaus bzw. des Transpondersubstrats ein Umschlagen der beiden Seitenbereiche des Sicherheitslagenaufbaus möglich.

Vorteilhaft ist es, wenn zur Ausbildung eines Buchdeckeleinbands die Decklagen mit einer inneren und einer äußeren Einbanddecklage versehen sind.

Das erfindungsgemäße Identifikationsdokument mit einem Sicherheitslagenaufbau der vorstehend beschriebenen Art ist in einer Ausführung im Chipkartenformat, also nach Art einer sogenannten "Chipkarte", ausgebildet.

In einer zweiten Ausführung ist das erfindungsgemäße Identifikationsdokument mit einem Sicherheitslagenaufbau nach der vorstehend beschriebenen Art mit zumindest einer in einem Buchdeckeleinband angeordneten Ausweisseite versehen.

Im vorstehenden Fall erweist es sich als besonders vorteilhaft, wenn die zumindest eine Ausweisseite mit dem Sicherheitslagenaufbau versehen ist. Alternativ ist es möglich, den Buchdeckeleinband mehrlagig ausgebildet vorzusehen, derart, dass der Sicherheitslagenaufbau zwischen einer inneren und einer äußeren Einbanddecklage angeordnet ist.

Nachfolgend werden bevorzugte Ausführungsbeispiele des Verfahrens zur Herstellung eines Sicherheitslagenaufbaus bzw. Ausführungsbeispiele für einen Sicherheitslagenaufbau unter Bezugnahme auf die Zeichnung näher erläutert.

Es zeigen:
- **Fig. 1**: einen Nutzenbogen mit zwei Transponder- substraten zur Herstellung von Ausweisseiten eines Personaldokuments in Draufsicht;
- **Fig. 2**: einen Nutzenbogen mit vier Transpondersubstra- ten zur Herstellung eines Dokuments zur Perso- nenidentifikation im Chipkartenformat;
- **Fig. 3a bis 3c**: die Herstellung eines Sicherheitslagenaufbaus in einem ersten Ausführungsbeispiel;
- **Fig. 4a bis 4c**: die Herstellung eines Sicherheitslagenaufbaus in einem zweiten Ausführungsbeispiel;
- **Fig. 5**: einen Nutzenbogen umfassend zwei Sicherheits- lagenaufbauten zur Ausbildung von Ausweissei- ten;
- **Fig. 6**: einen Nutzenbogen umfassend vier Sicherheits- lagenaufbauten zur Ausbildung von Personaldo- kumenten in Chipkartenformat;
- **Fig. 7**: eine schematische Darstellung der Anordnung eines Drahtleiters mittels einer Drahtleiterverle- geeinrichtung auf einem Transpondersubstrat;
- **Fig. 8**: eine vergrößerte Querschnittsdarstellung des in **Fig. 7** mit Schnittlinienverlauf VIII-VIII mar- kierten Querschnittbereichs;
- **Fig. 9**: eine Drahtverlegeeinrichtung zur Verlegung ei- nes Drahtleiters mittels Ultraschall;
- **Fig. 10**: eine Teilschnittdarstellung gemäß Schnittlinienverlauf X-X in den **Fig. 1** und **2**;
- **Fig. 11**: eine zur Darstellung in den **Fig. 1** und **2** alterna- tive Ausführungsform eines Transponder- substrats mit einer Substratausnehmung zur Aufnahme einer Chipanordnung;
- **Fig. 12**: eine Teilschnittdarstellung des in **Fig. 11** darge- stellten Transpondersubstrats gemäß Schnittli- nienverlauf XII-XII mit Platzierung einer Chip- anordnung in der Substratausnehmung;
- **Fig. 13**: eine **Fig. 12** entsprechende Darstellung des Transpondersubstrats während der Kontaktie- rung des Drahtleiters mit den Anschlussflächen der Chipanordnung.

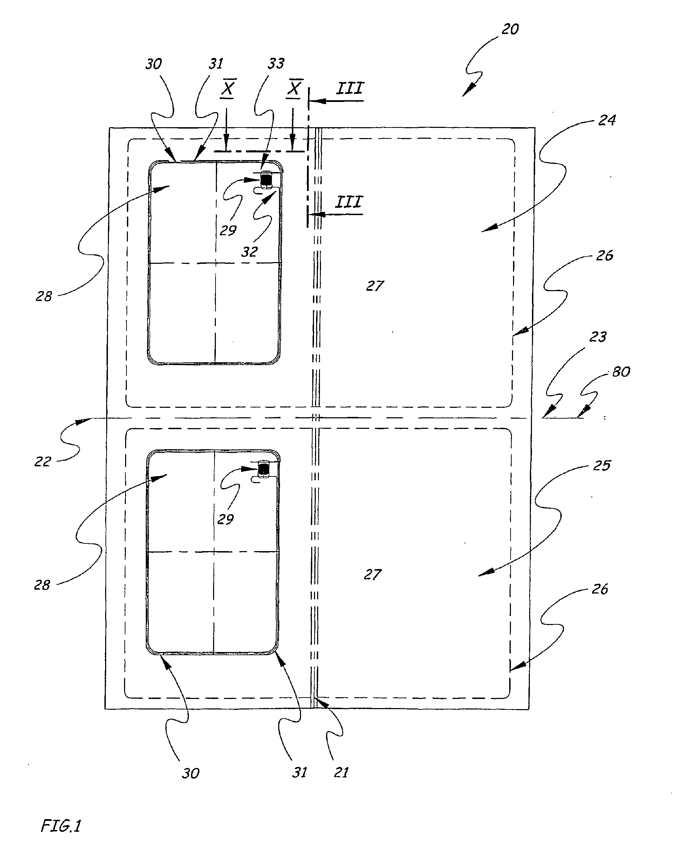

**Fig. 1** zeigt einen Nutzenbogen 20, der durch eine Faltachse 21 in zwei Seitenbereiche 22, 23 unterteilt ist, die auch ungleich ausgebildet sein können. Quer zur Faltachse 21 erstrecken sich zwei benachbarte, jeweils vom linken Seitenbereich 22 in den rechten Seitenbereich 23 verlaufende Doppelblattzuschnitte 24, 25 mit Umrissen 26, die durch den gestrichelten Linienverlauf dargestellt sind.

Die beiden identisch ausgebildeten, zu beiden Seiten einer Mittelachse 80 angeordneten Doppelblattzuschnitte 24, 25 sind jeweils als ein Transpondersubstrat 27 ausgebildet, das im linken Seitenbereich 22 mit jeweils einer Transpondereinheit 28 versehen ist. Die Transpondereinheit 28 umfasst eine Chipanordnung 29 und eine damit kontaktierte Antenne 30, die im Fall des dargestellten Ausführungsbeispiels als eine Drahtantenne aus einem auf der Oberfläche des Transpondersubstrats 27 verlegten Antennendraht 31 ausgebildet ist.

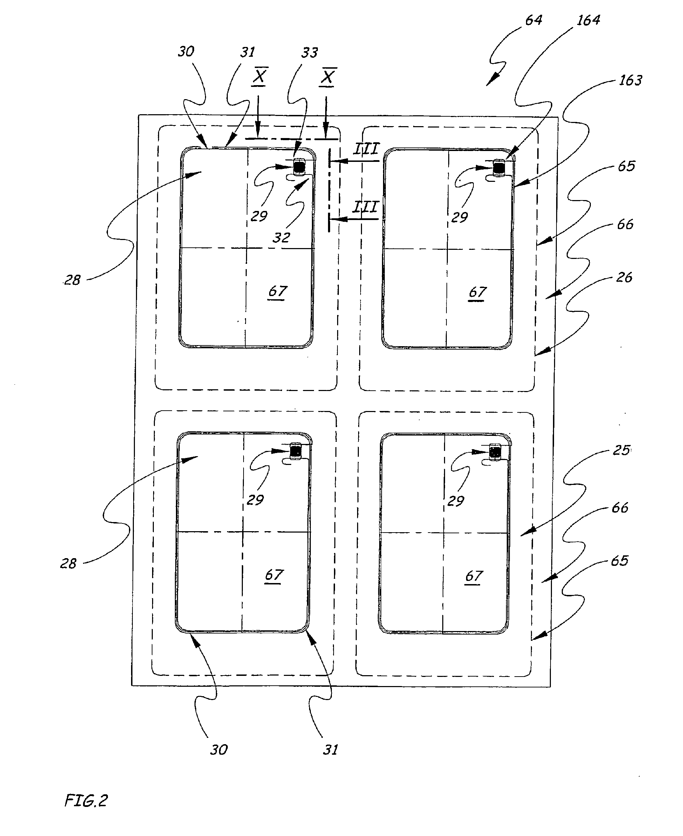

**Fig. 2** zeigt einen Nutzenbogen 64, der entsprechend den Umrissen 65, die durch den gestrichelten Linienverlauf dargestellt sind, in vier Chipkartenformate 66 aufgeteilt ist. Entsprechend den Chipkartenformaten 66 sind vier Transpondersubstrate 67 vorgesehen, die jeweils eine Transpondereinheit 28 aufweisen. Jede Transpondereinheit 28 umfasst eine Chipanordnung 29 und eine damit kontaktierte Antenne 30, die im Fall des dargestellten Ausführungsbeispiels als eine Drahtantenne aus einem auf der Oberfläche des Transpondersubstrats 67 verlegten Antennendraht 31 ausgebildet ist.

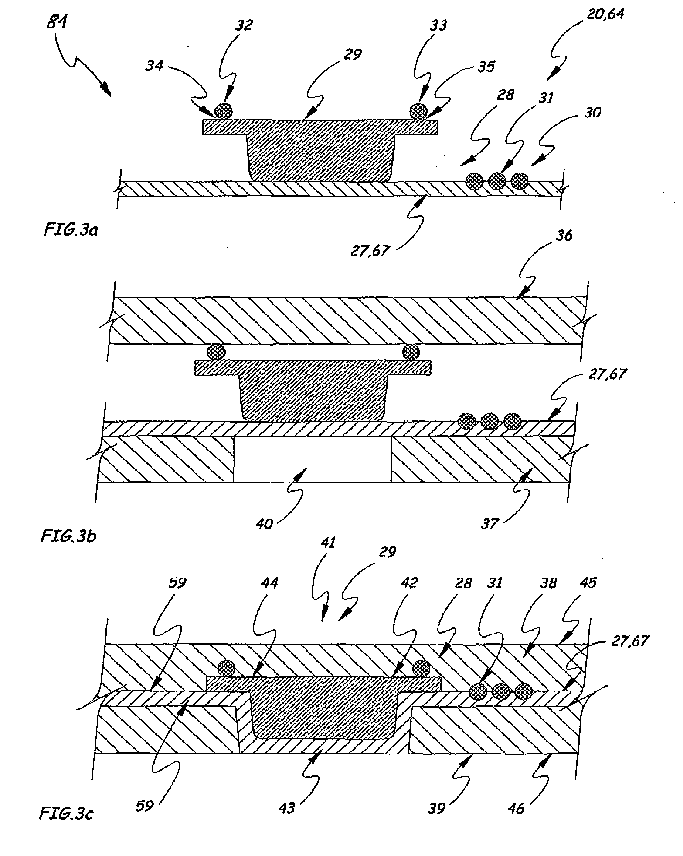

**Fig. 3a** zeigt eine gemäß Schnittlinienverlauf III-III in den **Fig. 1** und **2** dargestellte Teilschnittansicht des Transpondersubstrats 27 bzw. 67 während der Anordnung der Transpondereinheit 28 auf dem Transpondersubstrat 27 bzw. 67. Im Fall der in den **Fig. 3a bis 3c** dargestellten Verfahrensabfolge sind die im Nutzenbogen 20 bzw. 64 ausgebildeten Transpondersubstrate 27 bzw. 67 geschlossen, also fensterlos, ausgebildet und zur Herstellung der Transpondereinheit 28 wird die Chipanordnung 29 auf die Oberfläche des Transpondersubstrats 27 bzw. 67 appliziert. Nachfolgend erfolgt die Verlegung des Antennendrahts 31 in mehreren Antennenwindungen mit anschließender Kontaktierung von Drahtenden 32, 33 der Antenne 30 mit Außenkontakten 34, 35 der Chipanordnung 29 zur Herstellung einer Transponderlage 81.

Anschließend wird der Nutzenbogen 20 bzw. 64 aus einem thermoplastischen Material, wie beispielsweise Polykarbonat, Polypropylen, PET, oder einem Polyimid mit den darin ausgebildeten Transpondersubstraten 27 bzw. 67 beidseitig mit jeweils einem Nutzenbogen 36, 37 aus einem geschäumten Kunststoff, wie beispielsweise ein geschäumtes Polyethylen mit Siliciumdioxid als Füllstoff, das papierartige Eigenschaften aufweist, belegt. Wie aus den **Fig. 3b** und **c** ersichtlich, ist der Nutzenbogen 36, der zur Ausbildung einer Decklage 38 auf dem Transpondersubstrat 27 bzw. 67 dient, mit einer geschlossenen Oberfläche versehen, wohingegen der Nutzenbogen 37, der zur Ausbildung einer Decklage 39 auf der gegenüberliegenden Seite des Transpondersubstrats 27 bzw. 67 dient, mit Fensteröffnungen 40 versehen ist. Der in **Fig. 3b** dargestellte Lagenaufbau wird in einem hier nicht näher dargestellten Laminator zu einem in **Fig. 3c** dargestellten Sicherheitslagenaufbau 41 verarbeitet. Während des Laminiervorgangs bildet sich aufgrund der Einwirkung von Temperatur und Druck im Transpondersubstrat 27 bzw. 67 eine der Form einer Chipgehäusung 42 der Chipanordnung 29 angepasste Ausstülpung 43 aus, die in das Fenster 40 der Decklage 39 hineinragt. Aufgrund der Wärmeeinwirkung während des Laminiervorgangs kommt es auch zu einer oberflächlichen Erweichung des Transpondersubstrats 27 bzw. 67 mit der Folge, dass in zwischen dem Transpondersubstrat 27 bzw. 67 und den Decklagen 38, 39 ausgebildeten Grenzschichten 59 das thermoplastische Material des Transpondersubstrats 27 bzw. 67 in Hohlräume der aus einem porösen, elastischen Kunststoffmaterial gebildeten Decklagen 38, 39 eindringt und nach einer Erstarrung zu einer Verankerung der Decklagen 38, 39 an den Oberflächen des Transpondersubstrats 27 bzw. 67 führt. Aufgrund der porösen und elastischen Ausbildung des Kunststoffmaterials der Decklagen 38, 39 dringen aus der Ebene des Transpondersubstrats 27 bzw. 67 vorstehende Bereiche der Transpondereinheit 28, wie beispielsweise der Antennendraht 31 und ein hier vorgesehener Chipträger 44 der Chipanordnung 29, unter Verformung der Decklage 38 in die Decklage 38 ein, ohne sich auf einer freien Kontaktoberfläche 45 der Decklage 38 abzuzeichnen.

Wie **Fig. 3c** zeigt, ist Ergebnis des Laminiervorgangs ein Sicherheitslagenaufbau 41 mit planparallelen Kontaktoberflächen 45, 46.

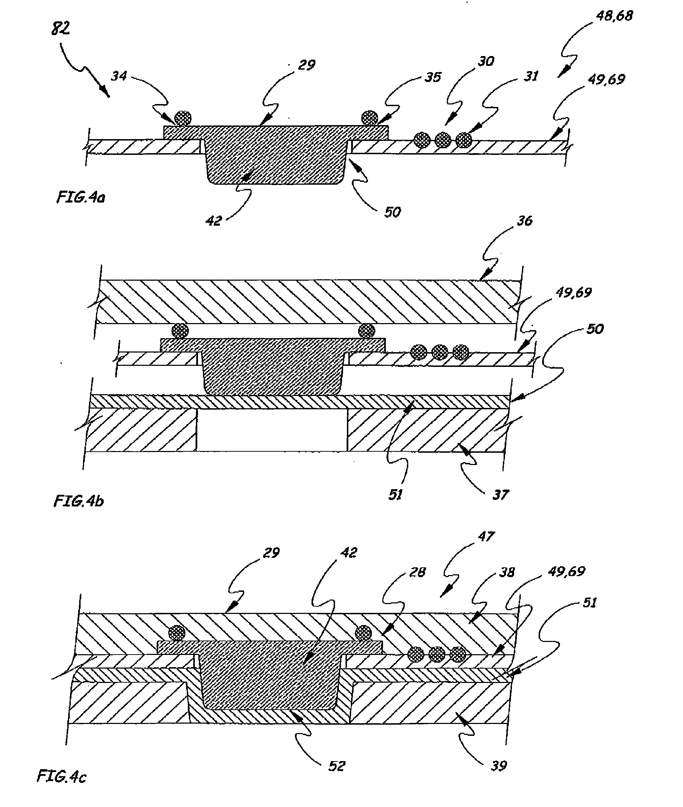

In den **Fig. 4a bis 4c** ist in einer alternativen Ausführungsform die Herstellung eines Sicherheitslagenaufbaus 47 dargestellt, wobei in den **Fig. 4a** bis **4c** in ihrer Ausführung mit den **Fig. 3a bis 3c** übereinstimmende Elemente mit entsprechend übereinstimmenden Bezugszeichen versehen sind.

**Fig. 4a** zeigt in Teilschnittdarstellung einen Nutzenbogen 48 bzw. 68, der im Unterschied zum Nutzenbogen 20 bzw. 64 Transpondersubstrate 49 bzw. 69 umfasst, die jeweils mit einer Fensteröffnung 50 versehen sind. Die Fensteröffnung 50 ermöglicht eine Anordnung der Chipanordnung 29 auf dem Transpondersubstrat 49 bzw. 69 mit versenkt in der Fensteröffnung 50 aufgenommener Chipgehäusung 42. Nach entsprechender Applikation der Chipanordnung 29 erfolgt in bereits unter Bezugnahme auf die **Fig. 3a** beschriebener Art und Weise zur Herstellung einer Transponderlage 82 die Verlegung des Antennendrahts 31 zur Ausbildung einer mit der Chipanordnung 29 in Außenkontakten 34, 35 kontaktierten Antenne 30.

Wie in **Fig. 4b** dargestellt, wird das Transpondersubstrat 49 bzw. 69 nachfolgend oberseitig mit einem Nutzenbogen 36 aus dem vorbeschriebenen porösen, elastischen Kunststoffmaterial belegt. Auf der Unterseite des Transpondersubstrats 49 bzw. 69 erfolgt die Anordnung eines Nutzenbogens 50 mit jeweils den Transpondersubstraten 49 bzw. 69 zugeordneten Siegellagen 51, die wie das Transpondersubstrat 49 bzw. 69 aus einem thermoplastischen Kunststoff bestehen. Auf dem Nutzenbogen 50 mit den Siegellagen 51 wird abschließend ein Nutzenbogen 37 aus dem vorbeschriebenen porösen, elastischen Kunststoffmaterial aufgebracht.

Die in **Fig. 4b** dargestellte Lagenanordnung wird nachfolgend in einem Laminator zu einem Laminat verarbeitet, wobei sich nunmehr eine der Form der Chipgehäusung 42 entsprechende Ausstülpung 52 in den Siegellagen 51 ausbildet. Die Ausstülpung 52 ragt dabei in die Fensteröffnung 40 der unteren Decklage 39 hinein.

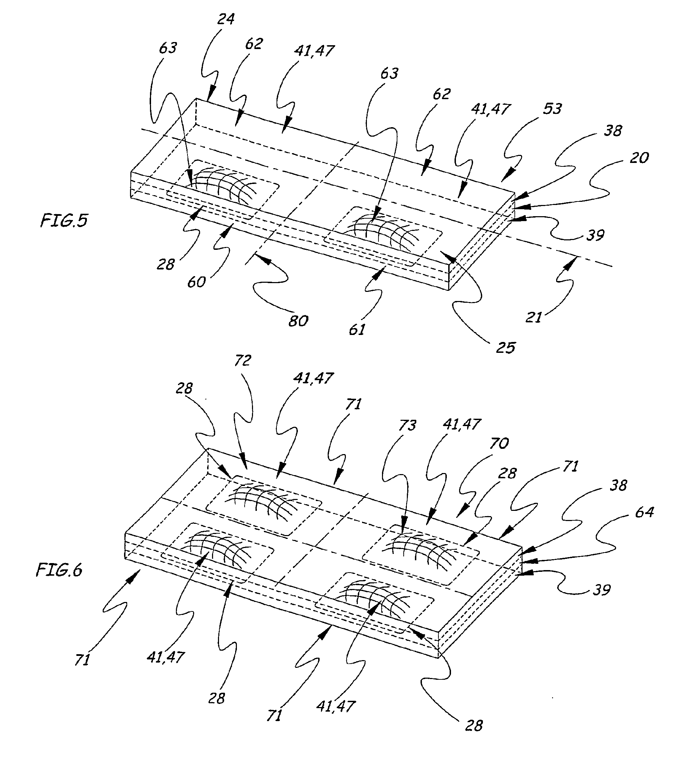

Ergebnis der in den **Fig. 3a** bis **3c** bzw. **4a bis 4c** dargestellten Verfahrensabfolge ist basierend auf dem in Fig. 1 dargestellten Nutzenbogen 20 ein in **Fig. 5** dargestellter Nutzenbogen 53 in Laminataufbau umfassend zwei durch die Mittelachse 80 **(****Fig. 1****)** voneinander abgeteilte Sicherheitslagenaufbauten 41 bzw. 47, die mit Transpondereinheiten 28 versehen sind. Entsprechend den Doppelblattzuschnitten 24, 25 kann nun jeder Sicherheitslagenaufbau 41 bzw. 47 nach Vereinzelung der Doppelblattzuschnitte 24, 25 zur Ausbildung einer Ausweisseite 60, 61 dienen. Als Authentizitätsmerkmal ist im vorliegenden Fall ein jeweils die Transpondereinheiten 28 überdeckender Bereich einer Sichtseite 62 der Decklage 38 mit einem Sicherheitsdruck 63 versehen.

In dem Fall, dass die Sicherheitslagenaufbauten 41, 47 in einen Buchdeckeleinband integriert werden sollen, werden die unteren und oberen Decklagen 38, 39 noch jeweils mit einer hier nicht näher dargestellten Einbanddecklage versehen, wobei in diesem Fall der Sicherheitsdruck auf einer Sichtseite einer Einbanddecklage angeordnet ist.

Ergebnis der in den **Fig. 3a bis 3c** bzw. **4a bis 4c** dargestellten Verfahrensabfolge ist basierend auf dem in **Fig**. **2** dargestellten Nutzenbogen 64 ein in **Fig. 6** dargestellter Nutzenbogen 70 in Laminataufbau umfassend vier Sicherheitslagenaufbauten 41 bzw. 47, die mit Transpondereinheiten 28 versehen sind. Entsprechend den Umrissen 65 **(****Fig. 2****)** kann nun jeder Sicherheitslagenaufbau 41 bzw. 47 nach Vereinzelung zur Ausbildung eines Personaldokuments 71 in Chipkartenformat dienen. Als Authentizitätsmerkmal ist im vorliegenden Fall ein jeweils die Transpondereinheiten 28 überdeckender Bereich einer Sichtseite 72 der Decklage 38 mit einem Sicherheitsdruck 73 versehen.

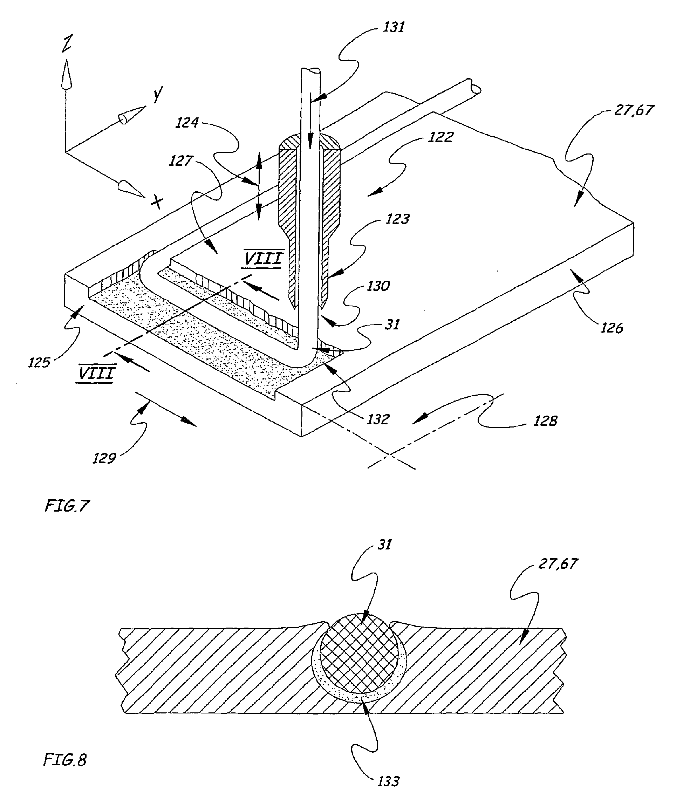

**Fig. 7** zeigt in einer schematischen Darstellung die Verlegung des Antennendrahts 31 auf dem Transpondersubstrat 27, 67 mittels einer durch Ultraschall beaufschlagten Drahtleiterverlegeeinrichtung 122 mit einem Drahtführer 123.

Die in **Fig. 7** dargestellte Drahtleiterverlegeeinrichtung 122 ist dreiachsig verfahrbar ausgebildet und wird mit Ultraschall beaufschlagt, der den Drahtführer 123 zu oszillierenden Querbewegungen (Pfeil 124) anregt, die in dem in **Fig. 7** dargestellten Beispiel senkrecht zu einer durch Seitenkanten 125, 126 einer Substratoberfläche 127 aufgespannten Verlegeebene 128 ausgerichtet sind.

Zur Verlegung wird der Antennendraht 31 unter Ausführung einer kontinuierlichen Vorschubbewegung in Richtung des Pfeils 131 aus einem Drahtführermundstück 130 hinausbewegt, wobei gleichzeitig der Drahtführer 123 eine parallel zur Verlegeebene 128 verlaufende Verlegebewegung 129 ausführt, die in **Fig. 7** am Verlauf des bereits auf dem Transpondersubstrat 27, 67 verlegten Drahtleiterabschnitts nachvollzogen werden kann. Dieser Verlegebewegung, die im Bereich der vorderen Seitenkante 125 in Richtung des Pfeils 129 verläuft, wird die oszillierende Querbewegung 124 überlagert. Hieraus resultiert ein entsprechend der Ultraschallfrequenz in schneller Folge wiederholtes Auftreffen oder -schlagen des Drahtführermundstücks 130 auf den Antennendraht 31, was zu einer Verdichtung und/oder Verdrängung des Substratmaterials im Bereich einer Kontaktstelle 132 führt.

**Fig. 8** zeigt in einer Schnittdarstellung, die in etwa dem in **Fig. 7** angedeuteten Schnittlinienverlauf VIII-VIII entspricht, die eingebettete Anordnung des Antennendrahts 31 im Transpondersubstrat 27, 67. Bei dem hier dargestellten Substrat kann es sich auch um eine PVC-Folie handeln, wobei zur Einbettung des Antennendrahts 31 dieser über die Drahtleiterverlegeeinrichtung 122 beispielsweise mit einer Ultraschalleistung von 50 W und einer Ultraschallfrequenz von 40 KHz beaufschlagt wird. Die Anpresskraft, mit der das Drahtführermundstück 130 gegen die Substratoberfläche 127 zur Anlage gebracht wird, kann bei dem vorgenannten Substratmaterial im Bereich zwischen 100 und 500 N liegen. Wie aus der Darstellung gemäß **Fig. 8** hervorgeht, wurde bei einem durchgeführten Versuch durch Einstellung der vorgenannten Parameter eine Einbettung des Antennendrahts 31 in das Transpondersubstrat 27, 67 im Wesentlichen aufgrund einer Verdichtung des Substratmaterials in einem hier sichelmondförmig ausgebildeten Verdichtungsbereich 133 des Substratmaterials erreicht.

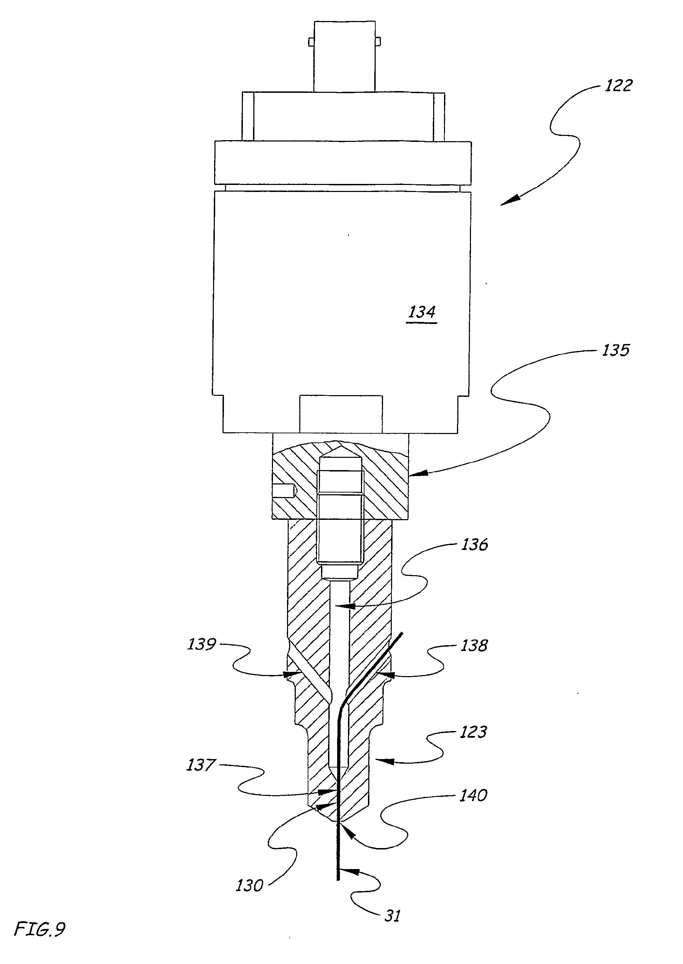

**Fig. 9** zeigt die Drahtleiterverlegeeinrichtung 122 in einer Einzeldarstellung mit einem Ultraschallgeber 134, der koaxial zum Drahtführer 123 angeordnet und mit diesem in einem Verbindungsbereich 135 starr verbunden ist. Die in **Fig. 9** dargestellte Drahtleiterverlegeeinrichtung 122 ist insgesamt rotationssymmetrisch ausgebildet. Der Drahtführer 123 weist eine zentrale Längsbohrung 136 auf, die im Bereich des Drahtführermundstücks 130 in eine Drahtkapillare 137 übergeht, die gegenüber der Längsbohrung 136 einen verengten, auf den Durchmesser des Antennendrahts 31 abgestimmten Durchmesser aufweist. Die Drahtführungskapillare 137 dient in erster Linie dazu, den Antennendraht 31 in der Verlegeebene 128 **(****Fig. 7****)** exakt ausrichten zu können.

Seitlich am Drahtführer 123 sind bei dem in **Fig. 9** dargestellten Ausführungsbeispiel oberhalb des Drahtführermundstücks in die Längsbohrung 136 einmündend zwei Drahtzuführkanäle 138, 139 angeordnet, die in Richtung auf das Drahtführermundstück 130 schräg nach unten verlaufen. Die Drahtzuführkanäle 138, 139 dienen zur seitlichen Einführung des Antennendrahts 31 in den Drahtführer 123, so dass der Antennendraht 31, wie in **Fig. 9** dargestellt, seitlich schräg in den Drahtzuführkanal 138, durch die Längsbohrung 136 hindurch und aus der Drahtführungskapillare 137 hinausgeführt durch den Drahtführer 123 hindurch verläuft. Dabei lässt die mehrfache Anordnung der Drahtzuführkanäle 138, 139 die Auswahl der jeweils günstigsten Drahtzuführungsseite am Drahtführer 123 zu.

Wie weiter aus **Fig. 9** hervorgeht, ist das Drahtführermundstück 130 im Bereich einer Drahtaustrittsöffnung 140 konvex ausgebildet, um eine für den Antennendraht 31 möglichst schonende Umlenkung im Bereich der Kontaktstelle 132 **(****Fig. 7****)** bzw. der Drahtaustrittsöffnung 140 bei dem in **Fig. 7** dargestellten Verlegevorgang zu ermöglichen.

Obwohl in **Fig. 9** nicht näher dargestellt, kann der Drahtführer 123 mit einer Drahtabtrenneinrichtung und einer Drahtvorschubeinrichtung versehen sein. Dabei kann die Drahtabtrennvorrichtung unmittelbar in das Drahtführermundstück 130 integriert sein.

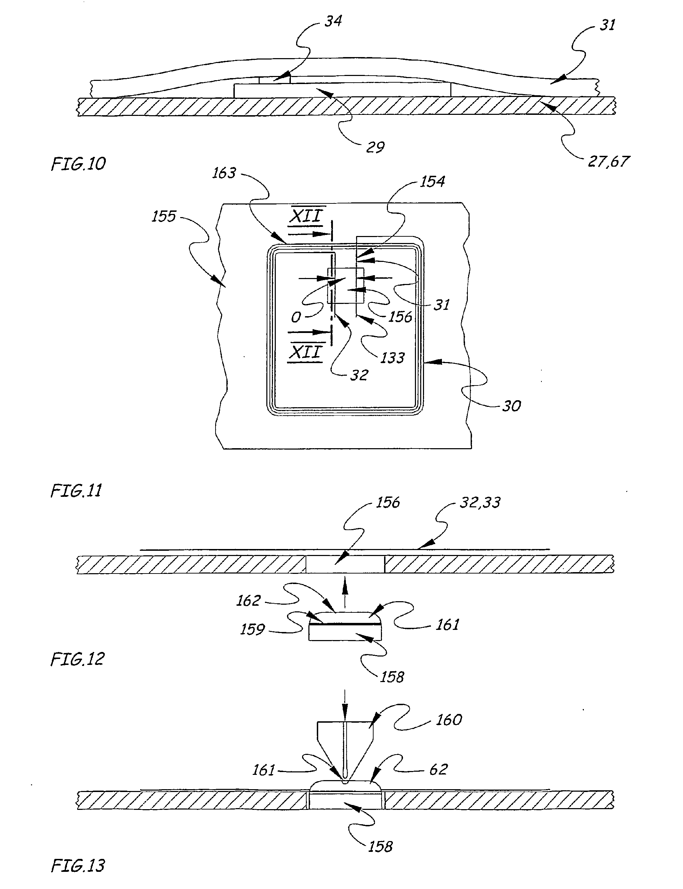

**Fig. 10** zeigt in einer Teilschnittdarstellung den über die Chipanordnung 29 verlaufenden Bereich des Antennendrahts 31 gemäß den **Fig. 1** und **2****.**

**Fig. 11** zeigt die Drahtenden 32 und 33 einer Antenne 30, die auf einem Transpondersubstrat 155 angeordnet ist, das eine Substratausnehmung 156 zur Aufnahme einer Chipanordnung 158 **(****Fig. 12****)** aufweist. Um die Drahtenden 32, 33 über die Substratausnehmung 156 hinwegführen zu können, wird, ähnlich wie im Bereich der Chipanordnung 29 bei dem in **Fig. 10** dargestellten Ausführungsbeispiel, die Ultraschallbeaufschlagung des Antennendrahts 31 im Bereich der Substratausnehmung 156 ausgesetzt.

Wie weiter aus **Fig. 11** und im Übrigen auch aus den **Fig. 1** und **2** zu ersehen ist, verlaufen die Kontaktenden 32, 33 parallel zueinander und quer zu einem benachbarten Drahtleiterstrang 163, wobei das Kontaktende 33 mit einem Brückenbereich 164 über den benachbarten Drahtleiterstrang 163 verläuft.

**Fig. 12** zeigt in einer Ansicht des Transpondersubstrats 155 entsprechend dem Schnittlinienverlauf XII-XII in **Fig. 11** die Platzierung der Chipanordnung 158 in der Substratausnehmung 156, bei der Anschlussflächen 159 der Chipanordnung 158 gegen die Drahtenden 32 und 33 zur Anlage gebracht werden.

**Fig. 13** zeigt die nachfolgende Verbindung der Anschlussflächen 159 der Chipeinheit 158 mit den Drahtenden 32 und 33 mittels einer Thermode 160, die unter Einwirkung von Druck und Temperatur eine stoffschlüssige Verbindung zwischen dem Antennendraht 31 und den Anschlussflächen 159 schafft.

Ferner wird aus den **Fig. 12** und **13** deutlich, dass die Substratausnehmung 156 so bemessen ist, dass sie die Chipanordnung 158 im Wesentlichen aufnimmt. Zur Vereinfachung der Ausrichtung der Anschlussflächen 159 der Chipanordnung 158 bei der der eigentlichen Kontaktierung vorausgehenden Platzierung der Chipeinheit 158 kann die Chipeinheit 158 auf ihrer die Anschlussflächen 159 aufweisenden Kontaktseite 161 mit einer hier stegartig ausgebildeten Ausrichtungshilfe 162 versehen sein. Die Ausrichtungshilfe 162 ist entsprechend dem Abstand a **(****Fig. 11****)** bemessen, den die Drahtenden 32, 33 im Bereich der Substratausnehmung 156 voneinander haben.

## Patentansprüche

1. Sicherheitslagenaufbau (41) zur Verwendung als Ausweisseite eines Personaldokuments oder zur Verwendung als Personaldokument im Chipkartenformat, wobei der Sicherheitslagenaufbau eine Transponderlage (81) aufweist, die auf einem Transpondersubstrat (27, 67) eine Chipanordnung (29, 158) und einen unter Ausbildung zumindest einer Spulenwindung in einer Ebene auf dem Transpondersubstrat angeordneten Drahtleiter (31) aufweist, der zur Ausbildung einer Transpondereinheit (28) mit Anschlussflächen (34, 45, 159) der Chipanordnung (29, 158) kontaktiert ist, wobei das Transpondersubstrat (27, 67) aus einem thermoplastischen Kunststoff gebildet und zwischen einer ersten Decklage (39), die gegenüberliegend einer Chipgehäusung (42) der Chipanordnung (29) angeordnet ist, und einer zweiten Decklage (38) aufgenommen ist und die Transponderlage mittels der Decklagen versiegelnd abgedeckt ist, wobei eine Sichtseite (62, 72) der ersten oder zweiten Decklage oder eine Sichtseite einer auf den Decklagen jeweils angeordneten Einbanddecklage mit einem personenspezifische Kenndaten aufweisenden Sicherheitsdruck (63, 73) versehen ist,
**dadurch gekennzeichnet,**
**dass** die Decklagen (38, 39) aus einem geschäumten Kunststoff gebildet sind, und die erste Decklage (39) eine Fensteröffnung (40) zur zumindest teilweisen Aufnahme der Chipgehäusung aufweist, wobei die Fensteröffnung (40) mit einem die Chipgehäusung (42) überdeckenden Teilbereich des Transpondersubstrats (27, 67) derart verfüllt ist, dass der Teilbereich flächenbündig mit einer Oberseite der ersten Decklage (39) angeordnet ist.

2. Sicherheitslagenaufbau (47) zur Verwendung als Ausweisseite eines Personaldokuments oder zur Verwendung als Personaldokument im Chipkartenformat, wobei der Sicherheitslagenaufbau eine Transponderlage (82) aufweist, die auf einem Transpondersubstrat (49, 69) eine Chipanordnung (29, 158) und einen unter Ausbildung zumindest einer Spulenwindung in einer Ebene auf dem Transpondersubstrat angeordneten Drahtleiter (31) aufweist, der zur Ausbildung einer Transpondereinheit (28) mit Anschlussflächen (34, 45, 159) der Chipanordnung (29, 158) kontaktiert ist, wobei das Transpondersubstrat (27, 67) aus einem thermoplastischen Kunststoff gebildet und zwischen einer ersten Decklage (39), die erste gegenüberliegend einer Chipgehäusung (42) der Chipanordnung (29) angeordnet ist, und einer zweiten Decklage (38) aufgenommen ist und die Transponderlage mittels der Decklagen versiegelnd abgedeckt ist, wobei eine Sichtseite (62, 72) den ersten oden zweiten Decklage oder eine Sichtseite einer auf den Dercklagen jeweils angeordneten Einbanddecklage mit einem personenspezifische Kenndaten aufweisenden Sicherheitsdruck (63, 73) versehen ist,
**dadurch gekennzeichnet,**
**dass** die Decklagen (38, 39) aus einem geschäumten Kunststoff gebildet sind, die erste Decklage (39) eine Fensteröffnung (40) zur zumindest teilweisen Aufnahme der Chipgehäusung aufweist, und gegenüberliegend der Chipgehäusung (42) zwischen dem Transpondersubstrat (49, 69) und der Decklagen (39) eine Siegellage (51) vorgesehen ist, wobei die Fensteröffnung (40) mit einem die Chipgehäusung (42) überdeckenden Teilbereich der Siegellage (51) derart verfüllt ist, dass der Teilbereich flächenbündig mit einer Oberseite der ersten Decklage (39) angeordnet ist.

3. Sicherheitslagenaufbau nach einem der vorangehenden Ansprüche,
**dadurch gekennzeichnet,**
**dass** der Drahtleiter (31) auf dem Transpondersubstrat (155) derart angeordnet ist, dass der Drahtleiter mit seinen für die Kontaktierung mit der Chipanordnung (158) vorgesehenen Kontaktenden (32, 33) über die in einer Substratausnehmung (156) angeordnete Chipanordnung (158) hinweggeführt und mit den Anschlussflächen (159) der Chipanordnung kontaktiert ist.

4. Sicherheitslagenaufbau nach einem der vorangehenden Ansprüche,
**dadurch gekennzeichnet,**
**dass** die Kontaktenden (32, 33) parallel zueinander und quer zu einem benachbarten Drahtleiterstrang (163) verlaufen.

5. Sicherheitslagenaufbau nach Anspruch 4,
**dadurch gekennzeichnet,**
**dass** ein Kontaktende (33) mit einem Brückenbereich (164) über den benachbarten Drahtleiterstrang (163) verläuft.

6. Sicherheitslagenaufbau nach einem der vorangehenden Ansprüche,
**dadurch gekennzeichnet,**
**dass** der Drahtleiter (31) zumindest anteilig mit seinem Drahtumfang in die Oberfläche (127) des Transpondersubstrats (27, 67) eingebettet ist.

7. Sicherheitslagenaufbau nach einem der Ansprüche 1 bis 5,
**dadurch gekennzeichnet,**
**dass** der Drahtleiter zumindest abschnittsweise mit der Oberfläche des Transpondersubstrats verklebt ist.

8. Sicherheitslagenaufbau nach einem der vorangehenden Ansprüche,
**dadurch gekennzeichnet,**
**dass** das Transpondersubstrat (27, 67, 49, 69) unter Verwendung eines Polyimids oder eines Polyimid-Derivates hergestellt ist.

9. Sicherheitslagenaufbau nach einem der vorangehenden Ansprüche,
**dadurch gekennzeichnet,**
**dass** das Transpondersubstrat eine Gewebestruktur aufweist.

10. Sicherheitslagenaufbau nach Anspruch 9,
**dadurch gekennzeichnet,**
**dass** die Gewebestruktur ein Nylongewebe aufweist.

11. Sicherheitslagenaufbau nach einem der vorangehenden Ansprüche,
**dadurch gekennzeichnet,**
**dass** zumindest die erste oder zweite Decklage (38, 39) einen Polyolefin-Schaumstoff aufweist.

12. Sicherheitslagenaufbau nach Anspruch 11,
**dadurch gekennzeichnet,**
**dass** zumindest die erste oder zweite Decklage (38, 39) einen PolyethylenSchaumstoff aufweist

13. Sicherheitslagenaufbau nach Anspruch 12,
**dadurch gekennzeichnet,**
**dass** der Polyethylen-Schaumstoff Siliciumdioxid als Füllstoff aufweist.

14. Sicherheitslagenaufbau nach einem der vorangehenden Ansprüche,
**dadurch gekennzeichnet,**
**dass** das Transpondersubstrat mehrlagig ausgebildet ist.

15. Sicherheitslagenaufbau nach einem der vorangehenden Ansprüche,
**dadurch gekennzeichnet,**
**dass** der Sicherheitslagenaufbau (41, 47) längs einer Faltachse (21) zumindest eine Querschnittsverringerung zur Definition einer Faltkante aufweist.

16. Sicherheitslagenaufbau nach einem der vorangehenden Ansprüche,
**dadurch gekennzeichnet,**
**dass** zur Ausbildung eines Buchdeckeleinbands die Decklagen (38, 39) des Sicherheitslagenaufbaus (41, 47) mit einer inneren und einer äußeren Einbanddecklage versehen sind.

17. Identifikationsdokument zur Personenidentifikation mit einem Sicherheitslagenaufbau nach einem der Ansprüche 1 bis 16,
**gekennzeichnet durch**
eine Ausführung im Chipkartenformat (66).

18. Identifikationsdokument zur Personenidentifikation mit einem Sicherheitslagenaufbau nach einem der Ansprüche 1 bis 16,
**gekennzeichnet durch**
eine Ausführung mit zumindest einer in einem Buchdeckeleinband angeordneten Ausweisseite (60, 61).

19. Identifikationsdokument nach Anspruch 18,
**dadurch gekennzeichnet,**
**dass** die zumindest eine Ausweisseite (60, 61) mit dem Sicherheitslagenaufbau (41, 47) versehen ist.

20. Identifikationsdokument nach Anspruch 18,
**dadurch gekennzeichnet,**
**dass** der Buchdeckeleinband mehrlagig ausgebildet ist und der Sicherheitslagenaufbau zwischen einer inneren und einer äußeren Einbanddecklage angeordnet ist.

## Claims

1. A security layered construction (41) for providing an ID page of an identification document or providing an identification document having chip card format, the security layered construction having a transponder layer (81), the transponder layer having a chip arrangement (29, 158) arranged on a transponder substrate (27, 67) and a wire conductor (31) positioned in one plane on the transponder substrate to implement at least one coil turn, which wire conductor is in contact with terminal areas (34, 35, 159) of the chip arrangement (29, 158) in order to form a transponder unit (28), the transponder substrate (27, 67) being made of a thermoplastic and being received between a first cover layer (39) positioned opposite a chip housing (42) of the chip arrangement (29) and a second cover layer (38), and the transponder layer being covered using the cover layers to form a seal, a viewing side (62, 72) of the first or second cover layer or a viewing side of a binding cover layer arranged on each of the cover layers being provided with security printing (63, 73) having person-specific identifying data.
**characterized in that**
the cover layers (38, 39) are made of a foamed plastic and the first cover layer (39) has a window opening (40) to at least partially receive the chip housing, the window opening (40) being filled up with a partial region of the transponder substrate (27, 67) overlapping the chip housing (42) in such a way that the partial region is flush with a top of the first cover layer (39).

2. A security layered construction (47) for providing an ID page of an identification document or providing an identification document having chip card format, the security layered construction having a transponder layer (82), the transponder layer having a chip arrangement (29, 158) arranged on a transponder substrate (49, 69) and a wire conductor (31) positioned in one plane on the transponder substrate to implement at least one coil turn, which wire conductor is in contact with terminal areas (34, 35, 159) of the chip arrangement (29, 158) in order to form a transponder unit (28), the transponder substrate (27, 67) being made of a thermoplastic and being received between a first cover layer (39) positioned opposite a chip housing (42) of the chip arrangement (29) and a second cover layer (38), and the transponder layer being covered using the cover layers to form a seal, a viewing side (62, 72) of the first or second cover layer or a viewing side of a binding cover layer arranged on each of the cover layers being provided with security printing (63, 73) having person-specific identifying data.
**characterized in that**
the cover layers (38, 39) are made of a foamed plastic, the first cover layer (39) has a window opening (40) to at least partially receive the chip housing, and a seal layer (51) is provided opposite the chip housing (42) between the transponder substrate (49, 69) and the cover layer (39), the window opening (40) being filled up with a partial region of the seal layer (51) overlapping the chip housing (42) in such a way that the partial region is flush with a top of the first cover layer (39).

3. The security layered construction according to one of the preceding Claims,
**characterized in that**
the wire conductor (31) is positioned on the transponder substrate (155) in such a way that the contact ends (32, 33) of the wire conductor provided for the contact with the chip arrangement (158) are guided off over the chip arrangement (158) positioned in a substrate recess (156) and are in contact with the terminal areas (159) of the chip arrangement.

4. The security layered construction according to one of the preceding Claims,
**characterized in that**
the contact ends (32, 33) run parallel to one another and transversely to a neighbouring wire conductor strand (163).

5. The security layered construction according to Claim 4,
**characterized in that**
a bridge region (164) of one contact end (33) runs over the neighbouring wire conductor strand (163).

6. The security layered construction according to one of the preceding Claims,
**characterized in that**
the wire circumference of the wire conductor (31) is at least partially embedded in the surface (127) of the transponder substrate (27, 67).

7. The security layered construction according to one of Claims 1 through 5,
**characterized in that**
at least some sections of the wire conductor are glued to the surface of the transponder substrate.

8. The security layered construction according to one of the preceding Claims,
**characterized in that**
the transponder substrate (27, 67, 49, 69) is produced using a polyimide or a polyimide derivative.

9. The security layered construction according to one of the preceding Claims,
**characterized in that**
the transponder substrate has a fabric structure.

10. The security layered construction according to Claim 9,
**characterized in that**
the fabric structure has a nylon fabric.

11. The security layered construction according to one of the preceding Claims,
**characterized in that**
at least the first or second cover layer (38, 39) has a polyolefin foam.

12. The security layered construction according to Claim 11,
**characterized in that**
at least the first or second cover layer (38, 39) has a polyethylene foam.

13. The security layered construction according to Claim 12,
**characterized in that**
the polyethylene foam has silicon dioxide as a filler.

14. The security layered construction according to one of the preceding Claims,
**characterized in that**
the transponder substrate is implemented as multi-layered.

15. The security layered construction according to one of the preceding Claims,
**characterized in that**
the security layered construction (41, 47) has at least one reduction in cross-section to define a folding edge along a folding axis (21).

16. The security layered construction according to one of the preceding Claims,
**characterized in that**
the cover layers (38, 39) of the security layered construction (41, 47) are provided with an inner and an outer binding cover layer to implement a book cover binding.

17. An identification document for personal identification, having a security layered construction according to one of Claims 1 through 16,
**characterized by**
an embodiment in the chip card format (66).

18. An identification document for personal identification, having a security layered construction according to one of Claims 1 through 16,
**characterized by**
an embodiment having at least one ID page (60, 61) positioned in a book cover binding.

19. The identification document according to Claim 18,
**characterized in that**
the at least one ID page (60, 61) is provided with the security layered construction (41, 47).

20. The identification document according to Claim 18,
**characterized in that**
the book cover binding is implemented as multi-layered and the security layered construction is positioned between an inner and an outer binding cover layer.

## Revendications

1. Structure de couches de sécurité (41) à utiliser comme page de pièce d'identité d'un document personnel ou à utiliser comme document personnel au format de carte à puce, moyennant quoi la structure de couches de sécurité présente une couche de transpondeur (81), qui présente sur un substrat de transpondeur (27, 67) un dispositif de puce (29, 158) et un fil conducteur (31) disposé dans un plan sur le substrat de transpondeur en formant au moins une spire de bobine, lequel fil est contacté par des surfaces de connexion (34, 45, 159) du dispositif de puce (29, 158) afin de réaliser une unité de transpondeur (28), moyennant quoi le substrat de transpondeur (27, 67) est formé à partir d'une matière plastique thermoplastique et est renfermé entre une première couche de couverture (39) disposée en vis-à-vis d'un logement de puce (42) du dispositif de puce (29) et une deuxième couche de couverture (38) et la couche de transpondeur est recouverte avec scellement au moyen des couches de couverture, moyennant quoi un côté visuel (62, 72) de la première ou la deuxième couche de couverture ou un côté visuel d'une couche de couverture de reliure respectivement disposée sur les couches de couverture est pourvu d'une impression de sécurité (63, 73) présentant des données d'identification spécifiques à une personne,
**caractérisée en ce que**
les couches de couverture (38, 39) sont formées à partir d'une matière plastique mousse et la première couche de couverture (39) présente une ouverture de fenêtre (40) pour recevoir au moins partiellement le logement de puce, moyennant quoi l'ouverture de fenêtre (40) est comblée par une zone partielle du substrat de transpondeur (27, 67) recouvrant le logement de puce (42), de telle sorte que la zone partielle soit disposée en affleurement de la surface d'un côté supérieur de la première couche de couverture (39).

2. Structure de couches de sécurité (47) à utiliser comme page de pièce d'identité d'un document personnel ou à utiliser comme document personnel au format de carte à puce, moyennant quoi la structure de couches de sécurité présente une couche de transpondeur (82), qui présente sur un substrat de transpondeur (49, 69) un dispositif de puce (29, 158) et un fil conducteur (31) disposé dans un plan sur le substrat de transpondeur en formant au moins une spire de bobine, lequel fil est contacté par des surfaces de connexion (34, 45, 159) du dispositif de puce (29, 128) afin de réaliser une unité de transpondeur (28), moyennant quoi le substrat de transpondeur (27, 67) est formé à partir d'une matière plastique thermoplastique et est renfermé entre une première couche de couverture (39) disposée en vis-à-vis d'un logement de puce (42) du dispositif de puce (29) et une deuxième couche de couverture (38) et la couche de transpondeur est recouverte avec scellement au moyen des couches de couverture, moyennant quoi un côté visuel (62, 72) de la première ou la deuxième couche de couverture ou un côté visuel d'une couche de couverture de reliure respectivement disposée sur les couches de couverture est pourvu d'une impression de sécurité (63, 73) présentant des données d'identification spécifiques à une personne,
**caractérisée en ce que**
les couches de couverture (38, 39) sont formées à partir d'une matière plastique mousse, la première couche de couverture (39) présente une ouverture de fenêtre (40) pour recevoir au moins partiellement le logement de puce, et une couche de scellement (51) est prévue en vis-à-vis du logement de puce (42) entre le substrat de transpondeur (49, 69) et la couche de couverture (39), moyennant quoi l'ouverture de fenêtre (40) est comblée par une zone partielle de la couche de scellement (51) recouvrant le logement de puce (42), de telle sorte que la zone partielle soit disposée en affleurement de la surface d'un côté supérieur de la première couche de couverture (39).

3. Structure de couches de sécurité selon une des revendications précédentes,
**caractérisée en ce que**
le fil conducteur (31) est disposé sur le substrat de transpondeur (155) de telle sorte que le fil conducteur avec ses extrémités de contact (32, 33) prévues pour le contact avec le dispositif de puce (158) s'étende au-delà du dispositif de puce (158) disposé dans un évidement du substrat (156) et contacte les surfaces de connexion (159) du dispositif de puce.

4. Structure de couches de sécurité selon une des revendications précédentes,
**caractérisé en ce que**
les extrémités de contact (32, 33) s'étendent parallèlement l'une à l'autre et transversalement à un brin de fil conducteur (163) adjacent.

5. Structure de couches de sécurité selon la revendication 4,
**caractérisée en ce qu'**
une extrémité de contact (33) s'étend par une zone de pontage (164) au dessus du brin de fil conducteur adjacent (163).

6. Structure de couches de sécurité selon une des revendications précédentes,
**caractérisée en ce que**
le fil conducteur (31) est intégré au moins sur une portion avec sa circonférence de fil dans la surface (127) du substrat de transpondeur (27, 67).

7. Structure de couches de sécurité selon une des revendications 1 à 5,
**caractérisée en ce que**
le fil conducteur est collé au moins sur des portions à la surface du substrat de transpondeur.

8. Structure de couches de sécurité selon une des revendications précédentes,
**caractérisée en ce que**
le substrat de transpondeur (27, 67, 49, 69) est fabriqué en utilisant un polyimide ou un dérivé de polyimide.

9. Structure de couches de sécurité selon une des revendications précédentes,
**caractérisé en ce que**
le substrat de transpondeur présente une structure de toile.

10. Structure de couches de sécurité selon la revendication 9,
**caractérisée en ce que**
la structure de toile présente une toile nylon.

11. Structure de couches de sécurité selon une des revendications précédentes,
**caractérisée en ce qu'**
au moins une de la première ou la deuxième couche de couverture (38, 39) présente une matière plastique mousse-polyoléfine.

12. Structure de couches de sécurité selon la revendication 11,
**caractérisée en ce qu'**
au moins une de la première ou la deuxième couche de couverture (38, 39) présente une matière plastique mousse-polyéthylène.

13. Structure de couches de sécurité selon la revendication 12,
**caractérisée en ce que**
la matière plastique mousse-polyéthylène présente du dioxyde de silicium comme matière de remplissage.

14. Structure de couches de sécurité selon une des revendications précédentes,
**caractérisée en ce que**
le substrat de transpondeur a une configuration multicouches.

15. Structure de couches de sécurité selon une des revendications précédentes,
**caractérisée en ce que**
la structure de couches de sécurité (41, 47) présente le long d'un axe de pliage (21) au moins une diminution de section transversale afin de définir une arête de pliage.

16. Structure de couches de sécurité selon une des revendications précédentes,
**caractérisée en ce que**
pour réaliser une reliure de couverture de livre, les couches de couverture (38, 39) de la structure de couches de sécurité (41, 47) sont pourvues d'une couche de couverture de reliure intérieure et d'une couche de couverture de reliure extérieure.

17. Document d'identification pour l'identification de personnes comportant une structure de couches de sécurité selon une des revendications 1 à 16,
**caractérisé par**
une configuration au format de carte à puce (66).

18. Document d'identification pour l'identification de personnes comportant une structure de couches de sécurité selon une des revendications 1 à 16,
**caractérisé par**
une configuration avec au moins une page de pièce d'identité (60, 61) disposé dans une reliure de couverture de livre.

19. Document d'identification selon la revendication 18,
**caractérisé en ce qu'**
au moins une page de pièce d'identité (60, 61) est pourvue de la structure de couches de sécurité (41, 47).

20. Document d'identification selon la revendication 18,
**caractérisé en ce que**
la reliure de couverture de livre a une configuration multicouches et la structure de couches de sécurité est disposée entre une couche de couverture de reliure intérieure et une couche de couverture de reliure extérieure.
